Europäisches Patentamt

European Patent Office

Office européen des brevets

(19)

(11) Numéro de publication : **0 326 572 B1**

(12) # FASCICULE DE BREVET EUROPEEN

(45) Date de publication du fascicule du brevet :
**06.05.92 Bulletin 92/19**

(51) Int. Cl.$^5$ : **H01F 7/02, G01R 33/44**

(21) Numéro de dépôt : **87906745.2**

(22) Date de dépôt : **13.10.87**

(86) Numéro de dépôt international :
**PCT/FR87/00393**

(87) Numéro de publication internationale :
**WO 88/02924 21.04.88 Gazette 88/09**

(54) **AIMANT PERMANENT CYLINDRIQUE A CHAMP INDUIT LONGITUDINAL.**

(30) Priorité : **17.10.86 FR 8614418**

(43) Date de publication de la demande :
**09.08.89 Bulletin 89/32**

(45) Mention de la délivrance du brevet :
**06.05.92 Bulletin 92/19**

(84) Etats contractants désignés :
**DE GB IT NL**

(56) Documents cités :
**GB-A- 2 112 645**
**US-A- 3 768 054**
**Patent Abstracts of Japan, volume 10, no. 58,**
**(E-386)(2115) 7 mars 1986, & JP-A-60210804**

(56) Documents cités :
**Control Engineering, volume 24, no. 11,**
**novembre 1977, A.S. Rashidi: "Rare earth**
**magnets improve response in linearactua-**
**tors", pages 56-58**

(73) Titulaire : **GENERAL ELECTRIC CGR S.A.**
**100, rue Camille-Desmoulins**
**F-92130 Issy les Moulineaux (FR)**

(72) Inventeur : **AUBERT, Guy**
**26, cours de la Libération**
**F-38100 Grenoble (FR)**

(74) Mandataire : **Schmit, Christian Norbert Marie**
**et al**
**Cabinet Ballot-Schmit 7, rue Le Sueur**
**F-75116 Paris (FR)**

EP 0 326 572 B1

## Description

La présente invention a pour objet un aimant permanent cylindrique à champ induit longitudinal. Elle trouve son application particulièrement dans le domaine médical où de tels aimants sont utilisés dans des expériences d'imagerie par résonance magnétique nucléaire à des fins d'aide au diagnostic. Elle peut néanmoins trouver son application dans d'autres domaines où des champs d'induction uniforme sont recherchés.

Dans le domaine de l'imagerie par résonance magnétique, il est nécessaire de placer les objets à imager, les patients dans le domaine médical, dans un champ d'induction magnétique élevé - couramment de 0,1 à 1,5 tesla - homogène et uniforme - quelques parties par millions de variation - dans un grand volume d'intérêt - couramment une sphère de cinquante centimètres de diamètre. Plusieurs classes de générateurs de champ magnétique ont été développées jusqu'à présent. Les principales sont : les aimants supraconducteurs, les aimants dits résistifs, et les aimants permanents. Les aimants permanents ont de nombreux avantages. En particulier ils ne nécessitent pas d'alimentation d'énergie pour produire le champ. Ils ne courent donc pas le risque de dérive de leur valeur de champ due à une dérive de leur alimentation, ou éventuellement du système d'évacuation de la chaleur dissipée.Ils ne nécessitent pas de moyen de refroidissement, en particulier avec des techniques de régulation sophistiquées, de l'écoulement des fluides cryogéniques. Leur température de fonctionnement est aisément stabilisée. Ils sont particulièrement adaptés à la réalisation de structures ou de systèmes produisant un champ principal transverse, c'est-à-dire perpendiculaire à une direction d'introduction des objets, des patients, dans l'aimant. Des structures cylindriques d'aimant permanent, produisant un champ magnétique uniforme, mais transverse au cylindre, dans un volume relativement élevé ont été décrites dans l'état de la technique. En particulier, dans une demande internationale de brevets n° W O 84/01226 déposée le 23 Septembre 1983 et publiée le 29 Mars 1984, D. LEE et Al. ont décrit un tel aimant.

Or pour des raisons historiques et techniques (insuffisance de l'intensité du champ induit produit par un aimant permanent) les premiers systèmes d'imagerie par résonance magnétique ont été conçus pour des aimants supraconducteurs ou des aimants résistifs dont les champs sont longitudinaux. L'adoption de structures d'aimant permanent à champ transverse ne conduit alors aux avantages de ces aimants qu'à condition de remettre en question le savoir faire acquis pour le reste des équipements de ces systèmes. Ces équipements annexes sont par exemple les antennes radiofréquences , les bobines de gradient ainsi que les dispositifs de correction de l'homogénéité du champ. C'est un objet de la présente invention ,que de proposer un aimant, à aimantation permanente, cylindrique, et à champ induit longitudinal qui permette l'utilisation des équipements déjà existants des systèmes d'imagerie par résonance magnétique nucléaire. Dans des conditions comparables d'utilisation, en particulier à volume utile d'examen égal, l'invention propose un aimant dont l'intensité du champ et donc le poids en matériaux magnétiques aimantés est comparable aux nouvelles structures d'aimant permanent à champ transverse. On connaît par le document Patent Abstract of Japan JP-A-60 210 804 et par le document GB-A-2 112 645 des structures à champ longitudinal. Mais d'une part l'homogénéité de ces champs est insuffisante et d'autre part, quand elle peut être meilleure l'aimant n'est plus à accès cylindrique. Dans le document GB-A-2 112 645 des bloc magnétiques utilisés ont des grosseurs qui augmentent au fur et à mesure de leur éloignement radial de la zone d'intérêt.

L'invention concerne un aimant permanent cylindrique à accès cylindrique le long de l'axe longitudinal de l'aimant et à champ induit longitudinal (zz') comportant deux structures (1,2) annulaires, disposées de part et d'autre du centre d'une zone d'intérêt de l'aimant aimantées (M) radialement par rapport à l'axe du cylindre avec une aimantation divergente dans une structure et convergente dans l'autre, les structures comportant chacune plusieurs ($n_a$) anneaux juxtaposés l'un après l'autre le long dudit axe longitudinal et dans chaque anneau plusieurs ($n_b$) blocs magnétiques répartis sur le pourtour dudit anneau caractérisé en ce que la grosseur des blocs augmente au fur et à mesure de leur éloignement axial de la zone d'intérêt.

L'invention sera mieux comprise à la lecture de la description qui suit et à l'examen des figures qui l'accompagnent. Celles-ci ne sont données qu'à titre indicatif et nullement limitatif de l'invention. Les figures montrent :
– Figure 1a à 1c : des vues en perspective d'aimants permanents cylindriques conformes à l'invention ;
– Figures 2a et 2b : des coupes respectivement transverses et longitudinales de l'aimant de la figure 1c.
– Figure 3 : un détail de montage de l'aimant de l'invention.

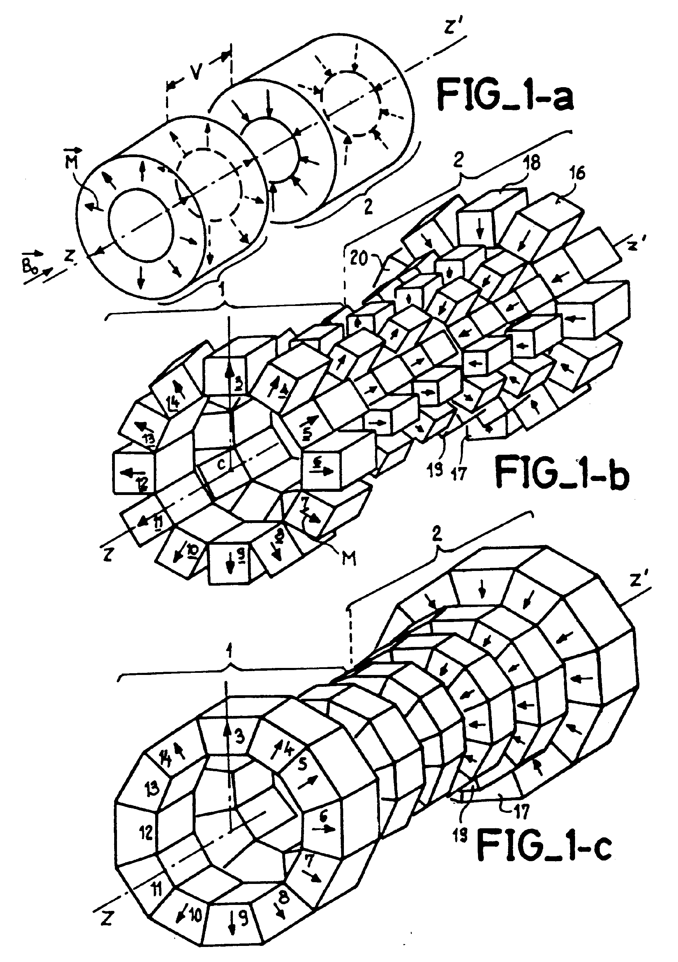

Les figures 1a à 1c représentent en perspective des aimants permanents cylindriques à champ induit longitudinal selon l'invention. Leur champ induit est orienté selon l'axe zz'. Le volume d'intérêt de ces aimants se situe dans leur milieu et dans leur volume intérieur creux. On peut considérer que ce volume d'intérêt a approximativement la forme d'une sphère. Les aimants sont divisés chacun en deux structures, respectivement 1 et 2, annulaires, c'est-à-dire par exemple comportant un certain nombre d'anneaux. Ces anneaux peuvent être formés par des blocs magnétiques, tels que 3 à 14 sur les figures 1b et 1c. Les deux structures de chaque aimant sont disposées de part et d'autre de la zone d'intérêt de cet aimant et sont aimantées, toutes deux, radialement. Les sens des aimantations $\overrightarrow{M}$ dans les blocs magnétiques sont représentés par des flèches. Le module de ces aimantations est constant en tous points de l'anneau. Dans les blocs des structures 1 l'aimantation est divergente, dans les blocs des structures 2 elle est convergente. D'une manière préférée les deux structures sont symétriques. Elles comportent toutes deux un même nombre $n_a$ d'anneaux. Elles comportent également dans des anneaux symétriques, un même nombre $n_b$ de blocs magnétiques répartis sur le pourtour de l'anneau. La distribution de l'aimantation est elle même antisymétrique. D'une manière préférée tous les anneaux de l'aimant possèdent de plus un même nombre $n_b$ de blocs. Ceci n'est cependant pas une obligation.

En particulier le nombre d'anneaux dans chaque structure pourrait être différent. De même le nombre de blocs dans chaque anneau pourraît être différent d'un anneau à l'autre. On verra plus loin que des raisons de simplification de fabrication et des raisons d'optimum de performance conduisent à la solution préférée, et, dans cette solution préférée, à la symétrie géométrique des structures 1 et 2 et à un nombre particulier de blocs dans les anneaux dépendant du nombre d'anneaux dans l'aimant.

La figure 1a correspond à une distribution théorique de l'aimantation qui conduit à la solution recherchée. Mais à l'époque actuelle on ne sait pas aimanter un matériau magnétique avec une distribution radiale pure. Aussi on approxime cette distribution par une distribution pseudo-radiale. Dans celle ci un anneau est constitué par un ensemble de blocs aimantés. Dans la réalisation préférée de la figure 1c, les blocs ont une section (perpendiculaire au champ induit) trapézoïdale. Dans une réalisation plus simple à fabriquer, figure 1b les blocs sont remplacés par des parallélipipèdes rectangles. Dans cette solution plus simple à fabriquer la consommation de matériau magnétique pour obtenir un champ donné dans un volume fixé est cependant plus grande

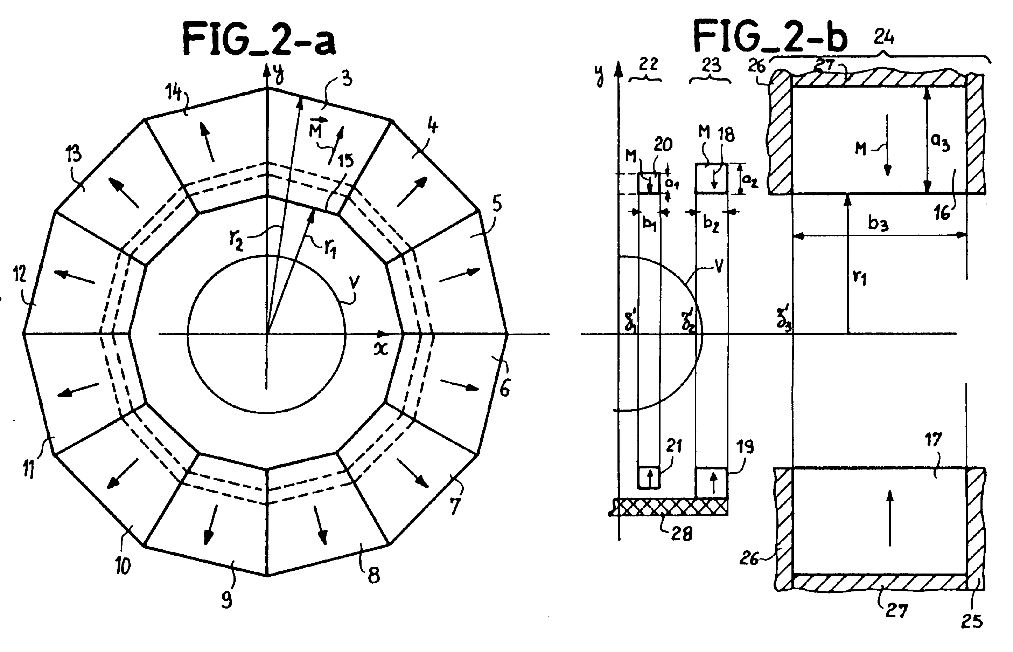

La figure 2a représente une coupe transverse d'un anneau de la structure 1 : par exemple l'anneau des blocs 3 à 14 de la figure 1c. Les blocs magnétiques à aimantation $\overrightarrow{M}$ constante et identique, en module et en direction dans tous les blocs, sont accolés les uns aux autres par leur base telle que 15. Ils circonsrivent le volume d'intérêt de l'aimant dans un prisme à base polygonale correspondant. La figure 2b montre une coupe longitudinale d'une moitié de l'aimant selon l'invention :celle de la structure 2. Cette structure comporte d'une manière préférée trois anneaux 22 à 24, et, dans chaque anneau, douze blocs identiques. Les anneaux sont disposés longitudinalement à l'axe z z'. Les anneaux ont de préférence un même diamètre intérieur $r_1$. Cette caractéristique est propice à une homogénéité de champ la plus forte compatible avec une masse minimum de matériau magnétique. Elle est de plus propice à une utilisation optimale du volume V d'intérêt à l'intérieur de l'aimant. On a trouvé que cette solution préférée conduisait à des blocs tels que 16 à 21 dont les hauteurs a et les longueurs b augmentent avec la distance au plan médian de l'anneau auquel ils appartiennent.

Il est possible de donner une représentation analytique, le cas échéant en coordonnées cylindriques ou sphériques, de la valeur du champ $B_0$ en fonction des coordonnées des lieux de l'espace, de la sphère d'intérêt V, où ce champ règne. Cette expression analytique peut se mettre sous une forme polynomiale dont les termes, fonction des puissances croissantes des variables x y z, sont affectés de coefficients représentatifs de l'homogénéité du champ produit. Il est connu de dire qu'un champ d'induction produit est homogène à un ordre h donné si les coefficients de ces termes sont nuls jusqu'aux termes de puissance h compris. On a alors découvert que le champ dans la zone d'intérêt pouvait être considéré comme homogène à un ordre h si le nombre d'anneaux $n_a$ dans chaque structure est supérieur ou égal à $(h + 1) / 4$ et si le nombre de blocs dans chaque anneau est supérieur ou égal à $(h + 1)$. Ces deux conditions simultanées conduisent à retenir une structure minimale en nombre de blocs, telle que le nombre de blocs dans chaque anneau soit égal à quatre fois le nombre d'anneau dans chaque structure.

A cet égard la structure représentée sur les figures 1b et 1c est optimum : il y a trois anneaux dans chaque structure et douze blocs dans chaque anneau. L'aimant est homogène à l'ordre 11. Un autre aimant également intéressent comporte dans chaque structure deux anneaux, et huit blocs dans chaque anneau. Cet autre aimant est homogène à l'ordre 7. Un aimant dont les structures ne comporterait qu'un anneau et quatre blocs par anneau serait homogène à l'ordre 3 seulement, et peu propre aux expérimentations de résonance magnétique nucléaire. Il pourrait cependant servir à d'autres fins. Les structures à quatre anneaux et à seize blocs par anneau, homogènes à l'ordre 15, doivent être réservées aux applications où le rayon intérieur $r_1$ du cylindre de l'aimant est faible. Pour des raisons de simplification de fabrication le nombre des blocs dans chaque anneau peut être supérieur au minimum indiqué par l'homogénéité à atteindre. Par contre, compte tenu de difficultés d'installation, le nombre des anneaux est toujours pris minimum. Il en résulte que, d'une manière préférée, le nombre de blocs dans un anneau est supérieur ou égal à quatre fois celui du nombre des anneaux de chacune des deux structures symétriques.

En réalisant tous les anneaux de l'aimant en un même matériau magnétique, et comportant donc une même aimantation interne intrinsèque, on a pu établir que les coordonnées longitudinales $z_i$ et les dimensions radiales $a_i$ et longitudinales $b_i$ des anneaux pouvaient être données en valeur réduite fonction du rayon $r_1$ commun à

tous les anneaux du cylindre d'aimant. Le tableau ci-dessous donne l'ensemble des cotes préférées de réalisation d'un exemple d'un tel aimant où le champ a l'homogénéité requise: ici h vaut 11.

| $-z'_1$ | $a_1$ | $b_1$ | $-z'_2$ | $a_2$ | $b_2$ | $-z'_3$ | $a_3$ | $b_3$ |
|---|---|---|---|---|---|---|---|---|
| 0,218 | 0,101 | 0,148 | 0,558 | 0,249 | 0,261 | 1,215 | 1,032 | 1,721 |

Connaissant la valeur $B_0$ d'un champ nominal d'induction à produire on adopte un matériau magnétique dont l'aimantation rémanente intrinsèque à saturation $B_r$ a une valeur correspondante dans un rapport $\alpha$ prédéterminé ($\alpha$ inférieur à 1): $B_0 = \alpha B_r$. On peut dire qu'à rayon interne fixé le volume de matériau magnétique augmente sensiblement comme $\alpha^2$. A titre indicatif, dans un exemple préféré de réalisation, pour un rayon interne $r_1$ de l'aimant valant quarante centimètres, on a obtenu un aimant dont le poids total vaut de l'ordre de onze tonnes avec une ferrite de Strontium et produit un champ interne dont l'intensité vaut 0, 12 teslas. L'induction rémanente de la ferrite utilisée vaut environ 0,4 tesla ($\alpha = 0,3$).

La construction de l'aimant proprement dit ne présente pas de difficulté particulière. Les anneaux peuvent être constitués, indépendamment les uns des autres, en maintenant les blocs déjà aimantés, par collage vissage ou autres moyens, entre deux flasques telles que 25 et 26 (fig 2b). Le cas échéant cette structure peut être renforcée par un élément de tube 27 qui vient contrecarrer les efforts radiaux subis par les blocs magnétiques. Chaque anneau peut être ainsi monté dans une armature dont la solidité, l'épaisseur, est calculée mécaniquement en fonction du poids des blocs de l'anneau et surtout des forces magnétiques qu'ils subissent. En outre, quand les structures sont symétriques, les blocs de deux anneaux symétriques peuvent être reliés extérieurement par des pièces en fer doux qui assurent un meilleur retour des lignes du champ d'induction d'un bloc à l'autre. Une telle pièce est représentée en 28 sous le bloc 19 de la figure 2b. La présence de ces pièces n'est cependant pas totalement nécessaire. Pour un même champ $B_0$ elles contribuent à réduire le volume de matériau pour aimant nécessaire mais elle rendent le calcul ab initio des dimensions des blocs ainsi que le reglage final de l'aimant plus délicats. Il faut alors calculer l'aimant, le construire, mesurer l'influence de ces pièces, et recommencer l'opération.

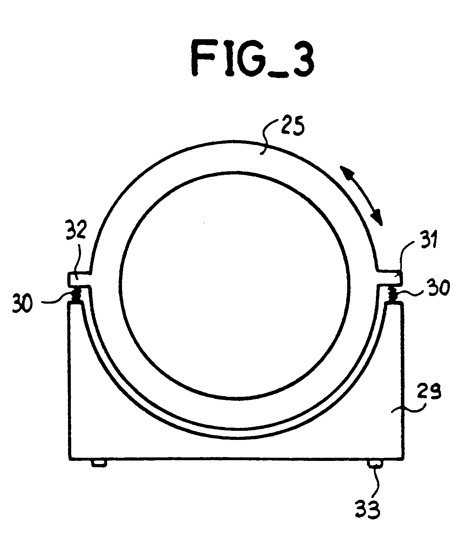

Lors du montage de l'aimant les anneaux maintenus par leurs flasques 25 et 26 sont approchés au dessus de berceaux tels que 29 (figure 3). Ces berceaux possèdent des vis de réglage 30 pour s'appuyer sur des pomelles 31 ou 32 solidaires des flasques. De cette manière on peut provoquer la rotation ou le décalage de l'anneau afin de corriger l'homogénéité du champ sur le site d'installation de l'aimant. On dispose ainsi d'une manière simple de corriger le champ. En outre les berceaux peuvent être montés sur des patins tels que 33 qui permettent leur déplacement longitudinalement à l'axe z'z. Il est alors aussi possible de régler la position d'un anneau dans cette direction de manière à corriger l'homogénéité du champ.

D'une manière préférée les matériaux magnétiques utilisés pour les blocs magnétiques sont des matériaux magnétiques anisotropes : des ferrites de Strontium ou de Baryum, des alliages Samarium-Cobalt ou au Fer-Néodyme-Bore. En effet dans une telle structure l'excitation démagnétisante dans les blocs n'est jamais colinéaire à l'aimantation que l'on souhaite radiale. On choisit parmi ces matériaux en fonction de leur prix et en fonction de l'intensité du champ $B_0$ que l'on veut obtenir.

**Revendications**

1. Aimant permanent cylindrique à accès cylindrique le long de l'axe longitudinal de l'aimant et à champ induit longitudinal (zz') comportant deux structures (1,2) annulaires, disposées de part et d'autre du centre d'une zone d'intérêt de l'aimant, aimantées (M) radialement par rapport à l'axe du cylindre avec une aimantation divergente dans une structure et convergente dans l'autre, les structures comportant chacune plusieurs ($n_a$) anneaux juxtaposés l'un après l'autre le long dudit axe longitudinal et dans chaque anneau plusieurs ($n_b$) blocs magnétiques répartis sur le pourtour dudit anneau caractérisé en ce que la grosseur des blocs augmente au fur et à mesure de leur éloignement axial de la zone d'intérêt.

2. Aimant selon la revendication 1 homogène à un ordre donné h, h étant une puissance de termes d'une expression analytique polynomiale représentant la valeur du champ induit ($B_0$), caractérisé en ce que le nombre d'anneaux dans chaque structure est supérieur ou égal à (h+1) / 4 et en ce que le nombre de blocs dans chaque anneau est supérieur ou égal à (h+1).

3. Aimant selon la revendication 1 ou la revendication 2 caractérisé en ce que les structures sont symétriques l'une de l'autre.

4. Aimant selon la revendication 3 caractérisé en ce que les diamètres intérieurs ($r_1$) des anneaux déterminés par les blocs sont tous égaux entre eux.

5. Aimant selon la revendication 2 caractérisé en ce que le nombre de blocs dans un anneau est supérieur ou égal à quatre fois le nombre d'anneaux dans la structure de cet anneau.

6. Aimant selon la reendication 4 caractérisé en ce que le nombre d'anneaux vaut deux et en ce que le nombre de blocs dans chaque anneau vaut huit.

7. Aimant selon la revendication 4 caractérisé en ce que le nombre d'anneaux vaut trois et en ce que le nombre de blocs dans chnaque anneau vaut douze.

8. Aimant selon l'une quelconque des revendications 1 à 2 cararterisé en ce qu'il comporte des moyens (33) pour déplacer les anneaux selon l'axe de l'aimant.

9. Aimant selon l'une quelconque des revendications 1 à 2 caractérisé en ce qu'il comporte des moyens (30 - 32) pour déplacer les anneaux orthogonalement à l'axe de l'aimant.

10. Aimant selon l'une quelconque des revendications 1 à 2 caractérisé en ce qu'il comporte des pièces (28) auxiliaires en matériau à forte perméabilité reliant les structures pour augmenter le champ produit, ou pour réduire le volume de matériau nécessaire pour produire un champ donné.

11. Aimant selon l'une quelconque des revendications 1 à 2 caratérisé en ce qu'il comporte des anneaux et des blocs disposés et conformés selon le tableau suivant pour réaliser un aimant à un ordre 11, avec des valeurs rapportées au rayon intérieur

| $-z'_1$ | $a_1$ | $b_1$ | $-z'_2$ | $a_2$ | $b_2$ | $-z'_3$ | $a_3$ | $b_3$ |
|---|---|---|---|---|---|---|---|---|
| 0,218 | 0,101 | 0,148 | 0,558 | 0,249 | 0,261 | 1,215 | 1,032 | 1,721 |

où $z'_i$ représente la côte longitudinale d'un bord de l'anneau i, où $a_i$ représente l'épaisseur radiale d'un bloc de cet anneau, et où $b_i$ représente la longueur d'un bloc mesurée longitudinalement.

## Patentansprüche

1. Zylindrischer Dauermagnet mit entlang der Längsachse des Magneten sich erstreckendem zylindrischem Zugang und mit induziertem Längsfeld ($zz''$) bestehend aus zwei ringförmigen Anordnungen (1 und 2), die sich zu beiden Seiten des Zentrums einer Interesssenzone des Magneten befinden und die mit in der einen Anordnung divergierender und in der anderen Anordnung konvergierender Magnetisierung in bezug auf die Achse des Zylinders radlal magnetisiert (M) sind, wobei die zwei Anordnungen jeweils mehrere ($n_a$) entlang der Längsachse in einer Reihe nebenaneinder liegenden Ringe umfassen, sowie aus mehreren ($n_b$) in jedem Ring angeordneten magnetisierten Blöcken, die am Umfang des jeweiligen Ringes vertelt sind, dadurch gekennzeichnet, daß die Größe der Blöcke gemäß deren axialer Entfernung von der Interesssenzone zunimmt.

2. Homogener, eine gegebene Ordnung h aufweisender Magnet nach Anspruch 1, wobei h ein Energieterm einer polynomen analytischen Gleichung ist, die den Wert des induzierten Feldes ($B_0$) darstellt, dadurch gekennzeichnet, daß die Anzahl der sich in jeder Anordung befinden Ringe größer als oder gleich (h+1)/4 ist und daß die Anzahl der Blöcke größer als oder gleich (h+1) ist.

3. Magnet nach Anspruch 1 or Anspruch 2, dadurch gekennzeichnet, daß die Anordnungen in bezug aufeinander symmetrisch sind.

4. Magnet nach Anspruch 3, dadurch gekennzeichnet, daß die Innendurchmesser ($r_1$) der durch die Blöcke festgelegten Ringe untereinander gleich sind.

5. Magnet nach Anspruch 2, dadurch gekennzeichnet, daß die Anzahl der Blöcke innerhalb eines Ringes größer oder gleich vier mal der Anzahl der Ringe in der Anordnung des Ringes ist.

6. Magnet nach Anspruch 4, dadurch gekennzeichnet, daß die Anzahl der Ringe gleich 2 und daß die Anzahl der Blöcke in jedem Ring 8 ist.

7. Magnet nach Anspruch 4, dadurch gekennzeichnet, daß die Anzahl der Ringe gleich 3 und daß die Anzahl der Blöcke in jedem Ring 12 ist.

8. Magnet nach einem der Ansprüche 1 und 2, dadurch gekennzeichnet, daß er Einrichtungen (33) zur Verschiebung der Ringe entlang der Achse der Magneten umfaßt.

9. Magnet nach einem der Ansprüche 1 und 2, dadurch gekennzeichnet, daß er Einrichtungen (30 - 32) zur Verschiebung der Ringe senkrecht zur Achse des Magneten umfaßt.

10. Magnet nach einem der Ansprüche 1 und 2, dadurch gekennzeichnet, daß er aus einem Material mit hoher Permeabilität bestehende Teile (28) umfaßt, die die Anordnungen verbinden und dabei das sich ergebende Feld erhöhen oder die das Volumen des zur Erzeugung eines erwünschten Feldes benötigten Materials vermindern.

11. Magnet nach einem der Ansprüche 1 und 2, dadurch gekennzeichnet, daß, um einen Magneten der Ordnung 11 zu bilden, er Ringe und Blöcke umfaßt die in bezug auf ihre Anordung und ihre Eigenschaften folgender, auf einen Innenradius bezogene Werte enthaltender Tabelle entsprechen:

| $-z'_1$ | $a_1$ | $b_1$ | $-z'_2$ | $a_2$ | $b_2$ | $-z'_3$ | $a_3$ | $b_3$ |
|---|---|---|---|---|---|---|---|---|
| 0,218 | 0,101 | 0,148 | 0,558 | 0,249 | 0,261 | 1,215 | 1,032 | 1,721 |

wobei $z'_1$ die Längsseite eines Randes eines Ringes i, $a_1$ die radiale Dicke eines Blockes dieses Ringes und $b_1$ die in der Längsrichtung gemessene Länge eines Blockes darstellt.

## Claims

1. Cylindrical permanent magnet with cylindrical access along the longitudinal axis of the magnet and with a longitudinal induced field (zz') comprising two annular structures (1.2) positioned on the respective two sides of the centre of a 'zone of interest' of the magnet and magnetized (m) radially in relation to the axis of the cylinder with a magnetization which is divergent in one structure and convergent in the other, each of the structures comprising a number ($n_a$) of juxtaposed rings succeeding one another along the said longitudinal axis, each ring having a number ($n_b$) of magnetic blocks distributed over the periphery of the said ring, characterized by the fact that the size of the blocks increases in accordance with their axial distance from the 'zone of interest'.

2. Magnet in accordance with Claim, homogeneous to a given order h, h being a power of terms of a polynominal analytic expression representing the value of the induced field ($B_0$), characterized by the fact that the number of rings in each structure is greater than or equal to (h+1)/4 and that the number of blocks in each ring is greater than or equal to (h+1).

3. Magnet in accordance with Claim 1 or Claim 2, characterized by the fact that the structures are symmetrical to one another.

4. Magnet in accordance with Claim 3, characterized by the fact that the internal diameters ($r_1$) of the rings produced by the blocks are all equal to one another.

5. Magnet in accordance with Claim 2, characterized by the fact that the number of blocks in a ring is greater than or equal to four times the number of rings in the structure of the ring concerned.

6. Magnet in accordance with Claim 4, characterized by the fact that the number of rings is two and the number of blocks in each ring is eight.

7. Magnet in accordance with claim 4, characterized by the fact that the number of rings is three and that the number of blocks in each ring is twelve.

8. Magnet in accordance with either of Claims 1, 2, characterized by the fact that it comprises means (33) for the displacement of the rings in accordance with the axis of the magnet.

9. Magnet in accordance with either of Claims 1, 2, characterized by the tact that it comprises means (30-32) for the displacement of the rings orthogonally to the axis of the magnet.

10. Magnet in accordance with either of Claims 1, 2, characterized by the fact that it comprises auxiliary pieces (28) of a material of high permeability interconnecting the structures in order to increase the field produced or in order to reduce the volume of material required for the production of a given field.

11. Magnet in accordance with either of Claims 1, 2, characterized by the tact that it comprises rings and blocks positioned and constructed in accordance with the following table in order to produce a magnet to the order 11, with values related to the internal radius:

| $-z_1'$ | $a_1$ | $b_1$ | $-z_2'$ | $a_2$ | $b_2$ | $-z_3'$ | $a_3$ | $b_3$ |
|---|---|---|---|---|---|---|---|---|
| 0.218 | 0.101 | 0.148 | 0.558 | 0.249 | 0.261 | 1.215 | 1.032 | 1.721 |

wherein $z_i'$ represents the longitudinal measurement of an edge of the ring i, $a_i$ the radial thickness of a block of this ring and $b_i$ the length of a block measured longitudinally.

FIG_1-a

FIG_1-b

FIG_1-c

# FIG_2-a

# FIG_2-b

EP 0 326 572 B1

# FIG_3